# EUROPEAN PATENT APPLICATION

(11) **EP 4 283 803 A1**
(43) Date of publication of application: **29.11.2023**
(21) Application number: 22742676.4
(22) Date of filing: 21.01.2022
(51) Int. Cl.: H01S 5/028

(54) **LIGHT-EMITTING ELEMENT, SEMICONDUCTOR LASER ELEMENT, AND METHOD AND DEVICE FOR MANUFACTURING SAME**

(30) Priority: 22.01.2021 JP 2021008897
(71) Applicant: Kyocera Corporation, Kyoto-shi Kyoto 612-8501 (JP)
(72) Inventor: MURAKAWA, Kentaro, Kyoto-shi, Kyoto 612-8501 (JP)
(74) Representative: Viering, Jentschura & Partner mbB Patent- und Rechtsanwälte
(86) International application number: PCT/JP2022/002149
(87) International publication number: WO 2022/158557

(57) **Abstract**

A light-emitting element (1) includes a laminate (2) and a first insulating film (3). The laminate (2) has a plurality of semiconductor layers, and includes a first end surface (2a), a second end surface (2b) opposed to the first end surface (2a), and a pair of side surfaces (2c) connecting the first end surface (2a) and the second end surface (2b). The first insulating film (3) is located over at least one of the pair of side surfaces (2c) from the first end surface (2a).

## Description

### TECHNICAL FIELD

The present disclosure relates to a light-emitting element.

### BACKGROUND OF INVENTION

Conventionally, various light-emitting elements such as a semiconductor laser and a light-emitting diode have been proposed (for example, see Patent Document 1).

### CITATION LIST

### PATENT LITERATURE

Patent Document 1: JP 2005-203588A

### SUMMARY

A light-emitting element of the present disclosure includes a laminate having a plurality of semiconductor layers and including a first end surface, a second end surface opposed to the first end surface, and a pair of side surfaces connecting the first end surface and the second end surface and a first insulating film located over at least one of the pair of side surfaces from the first end surface.

### BRIEF DESCRIPTION OF THE DRAWINGS

FIG. 1 is a perspective view illustrating a light-emitting element according to an embodiment of the present disclosure.
FIG. 2 is a side view illustrating the light-emitting element in FIG. 1.
FIG. 3 is a side view illustrating a variation of the light-emitting element according to the embodiment of the present disclosure.
FIG. 4 is a side view illustrating a state in which the light-emitting element in FIG. 1 is mounted on a support base.
FIG. 5 is a cross-sectional view taken along line V-V in FIG. 4.
FIG. 6 is a side view illustrating a state in which a light-emitting element according to another embodiment of the present disclosure is mounted on a support base.
FIG. 7 is a cross-sectional view taken along line VII-VII in FIG. 6.
FIG. 8 is a cross-sectional view for explaining a mask forming step in a method for manufacturing a light-emitting element.
FIG. 9 is a cross-sectional view for explaining an element layer forming step in the method for manufacturing a light-emitting element.
FIG. 10 is a cross-sectional view for explaining the element layer forming step in the method for manufacturing a light-emitting element.
FIG. 11 is a cross-sectional view for explaining the element layer forming step in the method for manufacturing a light-emitting element.
FIG. 12 is a cross-sectional view for explaining the element layer forming step in the method for manufacturing a light-emitting element.
FIG. 13 is a cross-sectional view for explaining an element layer separating step in the method for manufacturing a light-emitting element.
FIG. 14 is a cross-sectional view for explaining the element layer separating step in the method for manufacturing a light-emitting element.
FIG. 15 is a cross-sectional view for explaining the element layer separating step in the method for manufacturing a light-emitting element.
FIG. 16 is a front view for explaining an insulating film forming step in the method for manufacturing a light-emitting element.
FIG. 17 is a cross-sectional view of an example of a semiconductor laser element.
FIG. 18 is a side view of an example of the semiconductor laser element.
FIG. 19 is a flowchart showing an example of the method for manufacturing a semiconductor laser element.
FIG. 20 is a block diagram illustrating a configuration of a manufacturing apparatus of the semiconductor laser element.
FIG. 21 is a cross-sectional view of another example of the semiconductor laser element.
FIG. 22 is a side view of another example of the semiconductor laser element.
FIG. 23 is a perspective view of an example of the semiconductor laser element.
FIG. 24 is a perspective view of an example of the semiconductor laser element.
FIG. 25 is a side view of the semiconductor laser element in FIG. 24.

### DESCRIPTION OF EMBODIMENTS

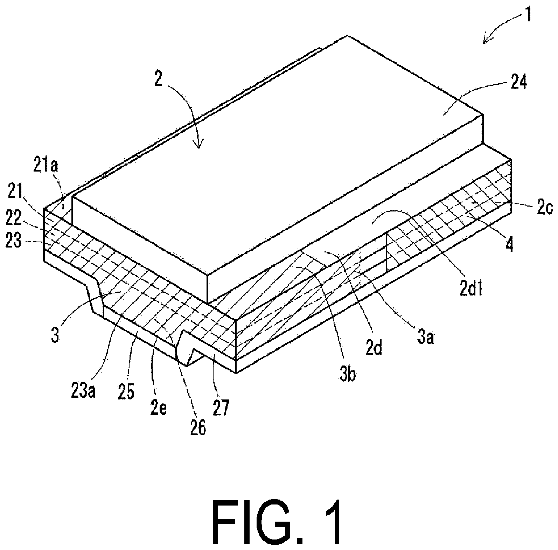

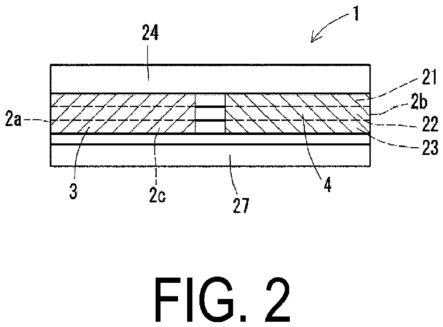

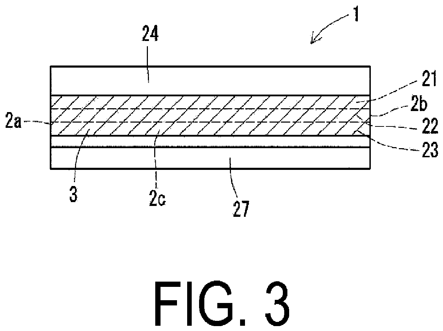

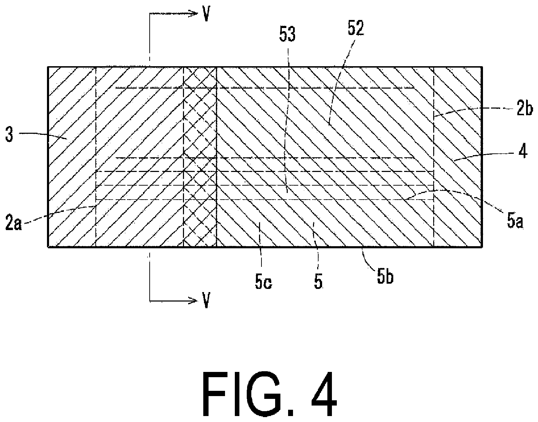

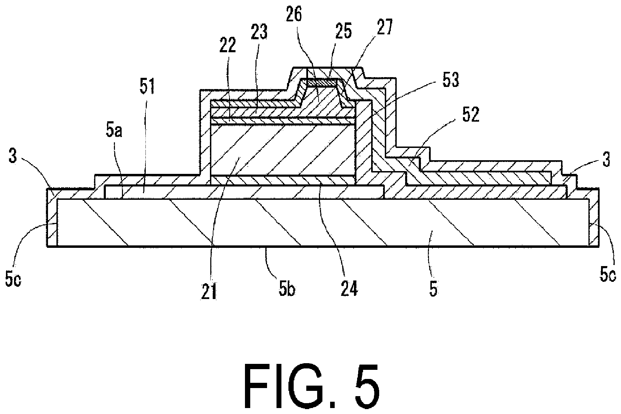

Hereinafter, a light-emitting element according to an embodiment of the present disclosure will be described with reference to the drawings. FIG. 1 is a perspective view illustrating the light-emitting element according to the embodiment of the present disclosure, FIG. 2 is a side view illustrating the light-emitting element illustrated in FIG. 1, and FIG. 3 is a side view illustrating the light-emitting element according to the embodiment of the present disclosure. FIG. 4 is a side view illustrating a state in which the light-emitting element of FIG. 1 is mounted on a support base, and FIG. 5 is a cross-sectional view taken along a cutting plane line V-V in FIG. 4. The side view illustrated in FIG. 3 corresponds to the side view illustrated in FIG. 2. In FIG. 4, a first insulating film and a second insulating film are hatched. The drawings are schematic, and dimensional ratios and the like in the drawings do not necessarily coincide with actual ones. In this specification, the terms "upper surface", "lower surface", and the like are used only for convenience of description, and do not specify the orientation of a light-emitting element during operation.

A light-emitting element 1 of the present embodiment includes a laminate 2 and a first insulating film 3.

The laminate 2 includes a first end surface 2a, a second end surface 2b opposed to the first end surface 2a, and a pair of side surfaces 2c connecting the first end surface 2a and the second end surface 2b. The first end surface 2a and the second end surface 2b are resonator surfaces (resonator end surfaces) of the light-emitting element 1. The laminate 2 further includes a first main surface 2d and a second main surface 2e connected to the first end surface 2a, the second end surface 2b, and the pair of side surfaces 2c.

For example, as illustrated in FIGs. 1 and 2, the laminate 2 has a substantially rectangular parallelepiped shape. The laminate 2 includes a plurality of semiconductor layers. The plurality of semiconductor layers are layered in a direction orthogonal to a longitudinal direction of the laminate 2 (hereinafter, also referred to as a layering direction).

The plurality of semiconductor layers include, for example, an n-type semiconductor layer 21, an active layer 22, and a p-type semiconductor layer 23. The n-type semiconductor layer 21, the active layer 22, and the p-type semiconductor layer 23 are exposed from the first end surface 2a, the second end surface 2b, and the pair of side surfaces 2c of the laminate 2. The n-type semiconductor layer 21 includes the first main surface 2d of the laminate 2, and the p-type semiconductor layer 23 includes the second main surface 2e of the laminate 2. In other words, the first main surface 2d corresponds to one main surface 21a of the n-type semiconductor layer 21, and the second main surface 2e corresponds to one main surface 23a of the p-type semiconductor layer 23.

The laminate 2 may have a length in a longitudinal direction of, for example, 50 to 1500 µm. The laminate 2 may have a thickness in a layering direction of, for example, 5 µm or more, or 10 µm or more.

The n-type semiconductor layer 21, the active layer 22, and the p-type semiconductor layer 23 are made of a GaN-based semiconductor such as gallium nitride (GaN), aluminum gallium nitride (AlGaN), indium gallium nitride (InGaN), or aluminum indium gallium nitride (AlInGaN). Here, the "GaN-based semiconductor" is composed of, for example, Al ₓGa_{y}In_{z}N (0 ≤ x ≤ 1; 0 ≤ y ≤ 1; 0 ≤ z ≤ 1; x + y + z = 1).

The n-type semiconductor layer 21 is an n-type GaN-based semiconductor doped with an n-type impurity. The p-type semiconductor layer 23 is a p-type GaN-based semiconductor doped with a p-type impurity. As the n-type impurity, Si or the like can be used. As the p-type impurity, Mg or the like can be used.

The active layer 22 may have a multiple quantum well structure in which barrier layers and well layers are alternately layered. The GaN-based semiconductor constituting the barrier layer and the GaN-based semiconductor constituting the well layer may differ in composition or composition ratio from each other.

A first electrode (also referred to as an n-type electrode) 24 is arranged on the first main surface 2d of the laminate 2. The n-type electrode 24 is connected to the n-type semiconductor layer 21. A second electrode (also referred to as a p-type electrode) 25 is arranged on the second main surface 2e of the laminate 2. The p-type electrode 25 is connected to the p-type semiconductor layer 23. The n-type electrode 24 may have a single-layer structure of Ti, Al, Au, or the like, or may have a multilayer structure in which these are combined. The p-type electrode 25 may have a single-layer structure of indium tin oxide (ITO), Ni, Au, or the like, or may have a multilayer structure in which these are combined.

For example, as illustrated in FIG. 1, the laminate 2 may have a ridge waveguide 26 provided in the p-type semiconductor layer 23. The ridge waveguide 26 may be formed over the entire laminate 2 in the longitudinal direction. When the laminate 2 includes the ridge waveguide 26, the p-type electrode 25 is arranged on a lower surface of the p-type semiconductor layer 23 in a region overlapping with the ridge waveguide 26 when viewed in the layering direction. An insulating layer 27 made of SiOz or the like is arranged in a region of the lower surface of the p-type semiconductor layer 23 where the p-type electrode 25 is not arranged.

The first end surface 2a and the second end surface 2b are the resonator surfaces of the laminate 2. In the light-emitting element 1, the first end surface 2a may be a light-emitting surface and the second end surface 2b may be a light reflecting surface, or the first end surface 2a may be a light reflecting surface and the second end surface 2b may be a light-emitting surface. At least one of the first end surface 2a and the second end surface 2b may be a cleavage plane formed by cleaving a precursor of the laminate 2. At least one of the first end surface 2a and the second end surface 2b may have a crystalline plane having a crystal orientation of the (1-100) plane. In other words, at least one of the first end surface 2a and the second end surface 2b may be a surface obtained by cleaving a precursor of the laminate 2 along an easy-to-cleave plane. Thus, the manufacturing step of the light-emitting element 1 can be simplified. The likelihood of the resonator surface of the laminate 2 being damaged by etching can be reduced.

At least one of the first end surface 2a and the second end surface 2b may be an etched mirror surface formed by performing vapor-phase etching such as inductively coupled plasma reactive ion etching, wet etching using a liquid such as KOH, or the like on the precursor of the laminate 2. Thus, even when the cleavage of the precursor of the laminate 2 is not easy, the resonator plane can be easily formed.

The first insulating film 3 is located extending from the first end surface 2a to at least one of the pair of side surfaces 2c. The first insulating film 3 may be made of an insulating material represented by the general formula AlₓSi_{w}O_{y}N_{z}. The first insulating film 3 may be a single-layer film of Al₂O₃, AIN, or the like. The first insulating film 3 may be a single-layer film of MgF₂, MgO, Nb₂O₅, SiO₂, Si₃N₄, TiO₂, Ta₂O₅, Y₂O₃, ZnO, ZrO₂, or the like, or a multi-layer film of a combination thereof. The first insulating film 3 can be formed using a sputtering method, an electron beam vapor deposition method, or the like. The thicker the laminate 2, the more likely the first insulating film 3 is to wrap around from the first end surface 2a to the pair of side surfaces 2c. The first insulating film 3 located on the first end surface 2a and the first insulating film 3 located on at least one of the pair of side surfaces 2c may have the same film configuration or different film configurations.

The light-emitting element 1 is a high-output light-emitting element with excellent reliability because the first insulating film 3 is located on the first end surface 2a, which reduces end face optical damage. In the light-emitting element 1, since the first insulating film 3 is located extending from the first end surface 2a to at least one of the pair of side surfaces 2c, the likelihood of a leakage current being generated between the n-type electrode 24 and the p-type electrode 25 can be reduced. Therefore, the light-emitting element 1 is a light-emitting element that is less likely to fluctuate in light-emitting characteristics and that has excellent long-term reliability.

For example, as illustrated in FIGs. 1 and 2, the light-emitting element 1 may include a second insulating film 4. The second insulating film 4 may be located extending from the second end surface 2b to at least one of the pair of side surfaces 2c.

The second insulating film 4 may be a multilayer film in which SiOz and TiOz are alternately layered. The second insulating film 4 may be a single-layer film made of an insulating material represented by the general formula AlₓSi_{w}O_{y}N_{z}. The second insulating film 4 may be a single-layer film made of Al₂O₃ or AlN. The second insulating film 4 may be a single-layer film of MgF₂, MgO, Nb₂O₅, SiO₂, Si₃N₄, TiO₂, Ta₂O₅, Y₂O₃, ZnO, ZrO₂, or the like, or a multi-layer film of a combination thereof. The second insulating film 4 can be formed using a sputtering method, an electron beam vapor deposition method, or the like. The second insulating film 4 located on the second end surface 2b and the second insulating film 4 located on at least one of the pair of side surfaces 2c may have the same configuration or may have different configurations.

When the second insulating film 4 is located on the second end surface 2b, leakage of light from the second end surface 2b can be reduced, and thus the light-emitting element 1 can have excellent luminous efficiency. In the light-emitting element 1, in a case where the second insulating film 4 is located extending from the second end surface 2b to at least one of the pair of side surfaces 2c, the likelihood of a leakage current being generated between the n-type electrode 24 and the p-type electrode 25 can be effectively reduced. Therefore, the light-emitting element 1 is a light-emitting element that is less likely to fluctuate in light-emitting characteristics and that has excellent long-term reliability.

The material used for the second insulating film 4 may be different from the material used for the first insulating film 3. Thus, the reflectance of the first insulating film 3 and the reflectance of the second insulating film 4 can be set independently of each other. As a result, optical damage to the end surface can be reduced, and leakage of light from the second end surface 2b can be reduced. Thus, the light-emitting element 1 can be a high-output light-emitting element with excellent luminous efficiency.

For example, as illustrated in FIG. 1, the first main surface 2d of the laminate 2 may have a non-electrode region 2d1 where the n-type electrode 24 is not arranged. In this case, the first insulating film 3 may be located over the non-electrode region 2d1 from the first end surface 2a. Since the first insulating film 3 is located from the first end surface 2a to the first main surface 2d on which the n-type electrode 24 is arranged, the likelihood of a leakage current being generated between the n-type electrode 24 and the p-type electrode 25 can be effectively reduced. The portion of the first insulating film 3 located on at least one of the pair of side surfaces 2c and the portion of the first insulating film 3 located in the non-electrode region 2d1 may have the same film configuration or different film configurations.

In the first insulating film 3, for example, as illustrated in FIG. 1, an end portion (end portion closer to the second end surface 2b) 3a of a portion located in at least one of the pair of side surfaces 2c may be located closer to the second end surface 2b than an end portion (end portion closer to the second end surface 2b) 3b of a portion located in the non-electrode region 2d1. Thus, the likelihood of a leakage current being generated between the n-type electrode 24 and the p-type electrode 25 can be reduced while maintaining a small region of the n-type electrode 24 covered with the first insulating film 3 (that is, while maintaining the conductivity between the n-type electrode 24 and the p-type electrode 25).

For example, as illustrated in FIG. 3, the first insulating film 3 or the second insulating film 4 may cover at least one of the pair of side surfaces 2c. In other words, one of the first insulating film 3 and the second insulating film 4 may cover the entirety of at least one of the pair of side surfaces 2c. Thus, the likelihood of a leakage current being generated between the n-type electrode 24 and the p-type electrode 25 can be effectively reduced.

In the first insulating film 3 and the second insulating film 4, the reflectance of the second insulating film 4 may be greater than the reflectance of the first insulating film 3. In this manner, optical damage to the end surface can be reduced, and leakage of light from the second end surface 2b can be reduced. Thus, the light-emitting element 1 can be a high-output light-emitting element with excellent luminous efficiency. The reflectance of the first insulating film 3 may be, for example, 5 to 99%. The reflectance of the second insulating film 4 may be, for example, 90 to 100%.

For example, as illustrated in FIGs. 4 and 5, the light-emitting element 1 may include a support base (base) 5. The support base 5 may be used as a submount when the light-emitting element 1 is mounted on a semiconductor package such as a TO-CAN type package. An n-type electrode pad (not illustrated) and a p-type electrode pad (not illustrated) are arranged on one main surface 5a of the support base 5. The n-type electrode 24 and the p-type electrode 25 are electrically connected to the n-type electrode pad and the p-type electrode pad, respectively. The n-type electrode 24 is connected to the n-type electrode pad via a first bonding layer 51. The p-type electrode 25 is connected to the p-type electrode pad via a wiring electrode 52. An insulating layer 53 is arranged between the wiring electrode 52 and the n-type semiconductor layer 21, the active layer 22, the p-type semiconductor layer 23, and the first bonding layer 51. The insulating layer 53 electrically insulates the n-type semiconductor layer 21, the active layer 22, the p-type semiconductor layer 23, and the first bonding layer 51 from the wiring electrode 52.

For example, as illustrated in FIGs. 4 and 5, at least one of the first insulating film 3 and the second insulating film 4 may be located on at least one of a pair of side surfaces 5c of the support base 5. The first insulating film 3 and the second insulating film 4 may or may not be arranged on the other main surface 5b of the support base 5. The first insulating film 3 and the second insulating film 4 may or may not cover the insulating layer 27 and the wiring electrode 52 located on the insulating layer 27.

For example, as illustrated in FIGs. 4 and 5, the first insulating film 3 or the second insulating film 4 may be located over both of the pair of side surfaces 2c. Since one of the first insulating film 3 and the second insulating film 4 is located extending to both of the pair of side surfaces 2c, the likelihood of a leakage current being generated between the n-type electrode 24 and the p-type electrode 25 can be effectively reduced. As a result, the light-emitting element 1 can be a light-emitting element that is less likely to have light-emitting characteristics that fluctuate and that has excellent long-term reliability.

For example, as illustrated in FIGs. 4 and 5, the first insulating film 3 or the second insulating film 4 may be located extending from the first end surface 2a or the second end surface 2b to the p-type electrode 25. Since the first insulating film 3 or the second insulating film 4 is in contact with the p-type electrode 25, the likelihood of a leakage current being generated between the n-type electrode 24 and the p-type electrode 25 can be effectively reduced. In the light-emitting element 1, the first insulating film 3 may be located from the first end surface 2a to the p-type electrode 25, and the second insulating film 4 may be located from the second end surface 2b to the p-type electrode 25. In this case, the likelihood of a leakage current being generated between the n-type electrode 24 and the p-type electrode 25 can be further effectively reduced.

For example, as illustrated in FIG. 4, on the pair of side surfaces 2c, the region where the second insulating film 4 is disposed may be larger than the region where the first insulating film 3 is disposed.

The thickness of the first insulating film 3 may be smaller than the thickness of the second insulating film 4. Thus, the likelihood of a leakage current being generated between the n-type electrode 24 and the p-type electrode 25 can be further effectively reduced.

For example, as illustrated in FIG. 4, the first insulating film 3 and the second insulating film 4 may overlap with each other on the pair of side surfaces 2c. Thus, the likelihood of a leakage current being generated between the n-type electrode 24 and the p-type electrode 25 can be further effectively reduced. The first insulating film 3 and the second insulating film 4 may be configured such that a portion of the second insulating film 4 is located between the side surface 2c and the first insulating film 3.

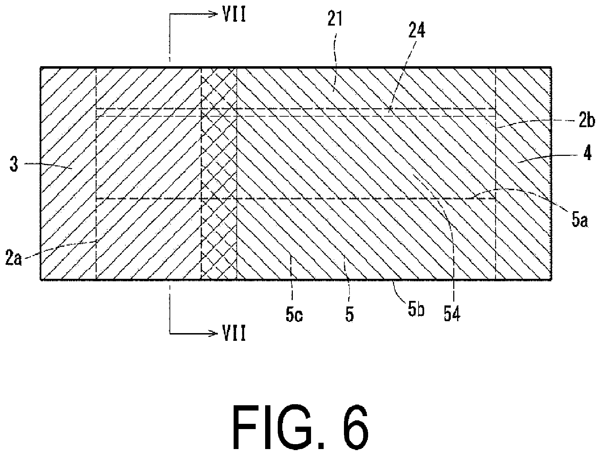

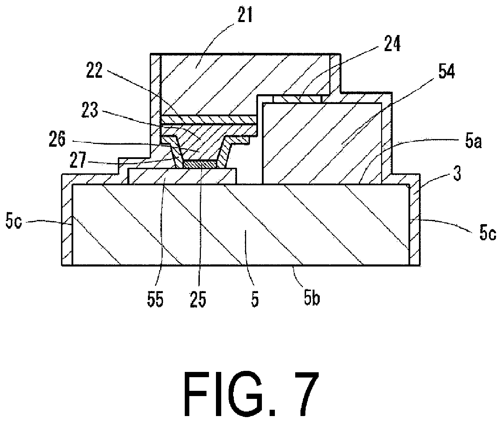

A light-emitting element according to another embodiment of the present disclosure will be described. FIG. 6 is a side view illustrating a light-emitting element according to another embodiment of the present disclosure, and FIG. 7 is a cross-sectional view taken along line VII-VII in FIG. 6. In FIG. 6, the first insulating film and the second insulating film are hatched. The light-emitting element of the present embodiment has the same configuration as the light-emitting element of the above-described embodiment except for the shape of the laminate and the position of the first electrode. Therefore, the same components are denoted by the same reference signs as those of the light-emitting element 1, and detailed description thereof will be omitted.

For example, as illustrated in FIGs. 6 and 7, a light-emitting element 1A of the present embodiment has a single-sided electrode structure in which both the n-type electrode 24 and the p-type electrode 25 are located on one side in the layering direction (vertical direction in FIGs. 6 and 7). The laminate 2 is removed from the p-type semiconductor layer 23 side until the n-type semiconductor layer 21 is exposed, and the n-type electrode 24 is arranged on the surface of the n-type semiconductor layer 21 exposed by the removal.

In the light-emitting element 1A having the single-sided electrode structure, the surface of the n-type semiconductor layer 21 connected to the n-type electrode 24 and the surface of the p-type semiconductor layer 23 connected to the p-type electrode 25 can be the (0001) plane of the GaN-based semiconductor. Therefore, the contact resistance between the n-type semiconductor layer 21 and the n-type electrode 24 and the contact resistance between the p-type semiconductor layer 23 and the p-type electrode 25 can be reduced. According to the light-emitting element 1A, the power consumption of the light-emitting element can be reduced.

For example, as illustrated in FIGs. 6 and 7, the light-emitting element 1A includes the support base 5. The support base 5 may be used as a submount when the light-emitting element 1A is mounted on a semiconductor package such as a TO-CAN type package. An n-type electrode pad (not illustrated) and a p-type electrode pad (not illustrated) are arranged on one main surface 5a of the support base 5. The n-type electrode 24 and the p-type electrode 25 are electrically connected to the n-type electrode pad and the p-type electrode pad, respectively. The n-type electrode 24 is connected to the n-type electrode pad via a third bonding layer 54. The p-type electrode 25 is connected to the p-type electrode pad via a fourth bonding layer 55.

For example, as illustrated in FIGs. 6 and 7, the first insulating film 3 is located from the first end surface 2a to at least one of the pair of side surfaces 2c of the laminate 2. Accordingly, the optical damage to the end surface of the light-emitting element 1A can be reduced, and thus a high-output light-emitting element with excellent reliability can be achieved. For example, as illustrated in FIGs. 6 and 7, the second insulating film 4 is located extending from the second end surface 2b to at least one of the pair of side surfaces 2c of the laminate 2. This can reduce the likelihood of generation of a leakage current between the n-type electrode 24 and the p-type electrode 25, so that the light-emitting element 1A is a light-emitting element that is less likely to have light-emitting characteristics that fluctuate and has excellent long-term reliability.

For example, as illustrated in FIGs. 6 and 7, at least one of the first insulating film 3 and the second insulating film 4 may be located on at least one of a pair of side surfaces 5c of the support base 5. The first insulating film 3 and the second insulating film 4 may or may not be arranged on the other main surface 5b of the support base 5. The first insulating film 3 and the second insulating film 4 may be in contact with at least one of the third bonding layer 54 and the fourth bonding layer 55.

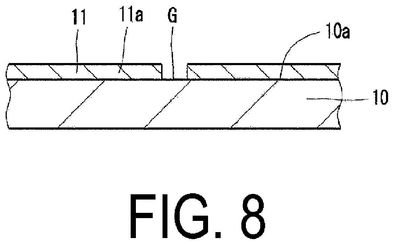

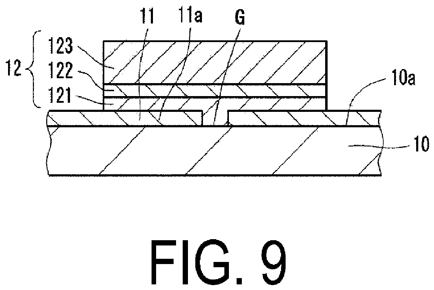

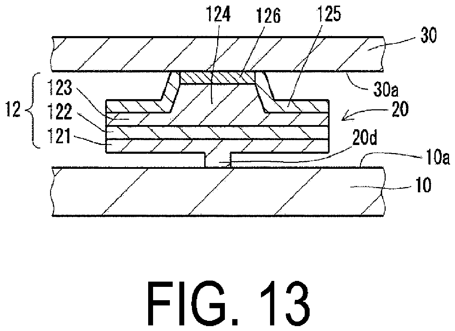

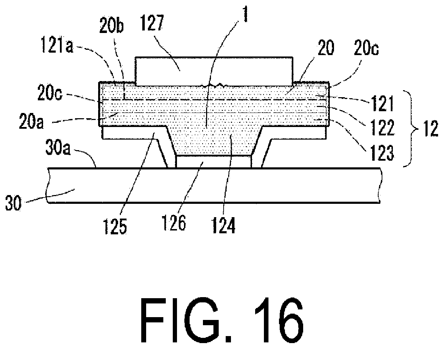

An example of a method for manufacturing the light-emitting element 1 will be described. The manufacturing method described below is a method for manufacturing the light-emitting element 1 by using an epitaxial lateral overgrowth (ELO) method, and includes a substrate preparing step, a mask forming step, an element layer forming step, an element layer separating step, and a dielectric film forming step. FIG. 8 is a cross-sectional view for describing a mask forming step in the method for manufacturing a light-emitting element, FIGs. 9 to 12 are cross-sectional views for describing an element layer forming step in the method for manufacturing a light-emitting element, FIGs. 13 to 15 are cross-sectional views for describing an element layer separating step in the method for manufacturing a light-emitting element, and FIG. 16 is a front view for describing an insulating film forming step in the method for manufacturing a light-emitting element.

### Substrate Preparing Step

The substrate preparing step is a step of preparing an underlying substrate (hereinafter, also simply referred to as a substrate) 10. The substrate 10 has one main surface 10a including a growth starting point of the semiconductor element layer. In the substrate 10, a front surface layer including the one main surface 10a is formed of a nitride semiconductor. The substrate 10 is, for example, a gallium nitride (GaN) substrate cut out from a GaN single-crystal ingot. The substrate 10 may be doped with an n-type impurity or a p-type impurity. As the substrate 10, a substrate in which a GaN-based semiconductor layer is formed on a surface of a Si substrate, a sapphire substrate, a SiC substrate, or the like may be used. The term "GaN-based semiconductor" as used herein refers to a semiconductor composed of, for example, AlₓGa_{y}In_{z}N (0 ≤ x ≤ 1; 0 ≤ y ≤ 1; 0 ≤ z ≤ 1; x + y + z = 1).

### Mask Forming Step

The mask forming step is a step of forming a mask 11 for reducing growth of the semiconductor element layer in a predetermined pattern on the one main surface 10a of the substrate 10. The mask 11 is made of, for example, SiOz, SiN, Al₂O₃, or the like, and can be formed using a photolithography technique and an etching technique.

For example, as illustrated in FIG. 8, the mask 11 may have a stripe pattern in which a plurality of band-shaped portions 11a extending in a first direction (depth direction in FIG. 8) are periodically disposed in a second direction (horizontal direction in FIG. 8) intersecting the first direction. The semiconductor element layer grows from a region (hereinafter, also referred to as a growth region) G which is not covered with the mask 11 on the one main surface 10a. The pattern of the mask 11 may be a stripe pattern or a lattice pattern in which a plurality of band-shaped portions are disposed crossing each other.

### Element Layer Forming Step

The element layer forming step is a step of vapor-growing a semiconductor element layer (hereinafter, also simply referred to as an element layer) 12 made of a nitride semiconductor from the growth region G of the substrate 10 to the band-shaped portion 11a of the mask 11 by using the ELO method.

A vapor phase growth method such as: a hydride vapor phase epitaxy (HVPE) method using a chloride as a group III (group 13 element) raw material; a metal organic chemical vapor deposition (MOCVD) method using an organic metal as a group III raw material; or a molecular beam epitaxy (MBE) method can be used in the element layer forming step.

When the element layer 12 is grown by the MOCVD method, first, the substrate 10 on which the mask 11 is pattern-formed is inserted into a reaction chamber of an epitaxial apparatus. Then, the substrate 10 is heated to a predetermined growth temperature (for example, 1050 to 1 100°C) while supplying a hydrogen gas, a nitrogen gas, or a mixed gas of hydrogen and nitrogen, and a group V raw material (group 15 element-containing) gas such as ammonia.

Subsequently, after the temperature of the substrate 10 is stabilized, in addition to the mixed gas and the group V raw material gas, a group III (group 13 element-containing) raw material such as trimethylgallium (TMG) is supplied to perform vapor phase growth of the element layer 12 from the growth region G. At this time, by supplying a source gas containing an n-type or p-type impurity and adjusting the doping amount, a nitride semiconductor layer of a desired conductivity type can be grown.

The growth of the element layer 12 is terminated before the element layers 12 respectively grown from the adjacent growth regions G come into contact with or overlap with each other. This is because, when the element layers 12 are in contact with each other, crystal defects such as cracks or threading dislocations are likely to occur in the contact portions. After the growth of the element layer 12 is completed, the substrate 10 is taken out from the vapor phase growth apparatus. In this manner, for example, as illustrated in FIG. 9, the element layer 12 can be formed by layering an n-type semiconductor layer 121, an active layer 122, and a p-type semiconductor layer 123 in this order from the substrate 10 side.

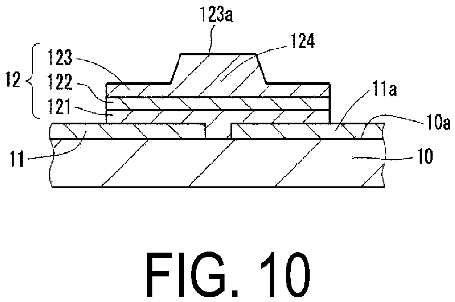

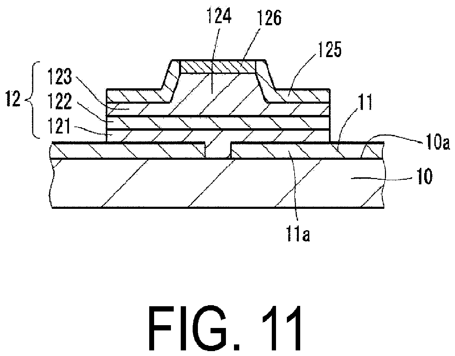

Next, for example, as illustrated in FIG. 10, the p-type semiconductor layer 123 is partially removed from one main surface (upper surface) 123a side to form a ridge waveguide 124. Subsequently, for example, as illustrated in FIG. 11, an insulating layer 125 made of SiOz or the like is formed on the side surface of the ridge waveguide 124 and in a region of the surface of the p-type semiconductor layer 123 located on the side of the ridge waveguide 124. Further, a p-type electrode 126 made of ITO, Ni, Au or the like is formed on an upper surface 123a of the p-type semiconductor layer 123. The ridge waveguide 124 can be formed using a photolithography technique and an etching technique. The insulating layer 125 can be formed by a plasma chemical vapor deposition (PCVD) method or the like. The p-type electrode 126 can be formed by a sputtering method, an electron beam vapor deposition method, or the like.

Subsequently, scribe lines for cleavage are formed at two positions in a first direction (a depth direction in FIG. 9) of the element layer 12 that has been grown, and then an external force is applied to the element layer 12 to break the element layer 12 along the scribe lines, thereby forming the first end surface and the second end surface. At least one of the first end surface and the second end surface may be an etched mirror surface. The first end surface and the second end surface may be formed at any time before the insulating film forming step is started.

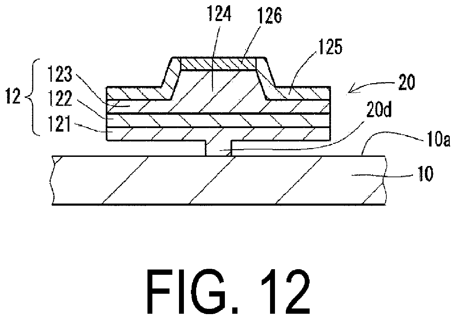

Then, the mask 11 is removed by etching using an etchant which does not substantially affect the element layer 12. Thus, for example, as illustrated in FIG. 12, a light-emitting element precursor 20 connected to the substrate 10 by a connecting portion 20d located on the one main surface 10a is obtained.

### Element Layer Separating Step

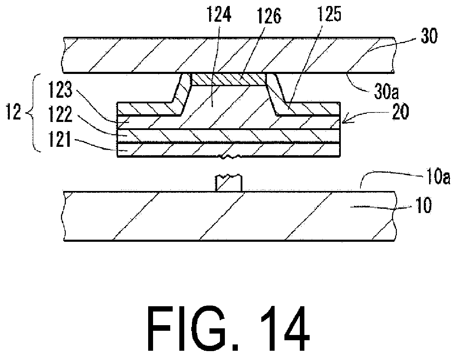

The element layer separating step is a step of separating the light-emitting element precursor 20 from the substrate 10 to form an n-type electrode 127. In the element layer separating step, first, a support substrate 30 in which an adhesive layer (not illustrated) is disposed on one main surface (lower surface) 30a is prepared. The adhesive layer may be, for example, solder made of AuSn or the like. Subsequently, the lower surface 30a of the support substrate 30 is made to oppose the one main surface 10a of the substrate 10. Subsequently, the support substrate 30 is pressed against the substrate 10, and the adhesive layer is heated, whereby the light-emitting element precursor 20 is bonded to the adhesive layer, for example, as illustrated in FIG. 13. Thereafter, an external force is applied to peel the light-emitting element precursor 20 integrated with the support substrate 30 upward, then the connecting portion 20d is broken, and thus the light-emitting element precursor 20 is pulled up from the one main surface 10a of the substrate 10. Thus, for example, as illustrated in FIG. 14, the light-emitting element precursor 20 can be separated from the substrate 10.

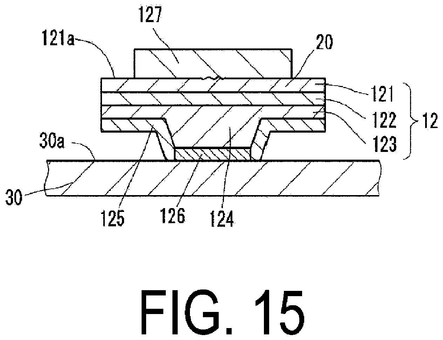

Subsequently, for example, as illustrated in FIG. 15, the n-type electrode 127 made of Ti, Al, Au, or the like is formed on an upper portion of one main surface (upper surface) 121a of the n-type semiconductor layer 121. The n-type electrode may be formed on only a part of the upper surface 121a so that the upper surface 121a has a non-electrode region (i.e., a region where the n-type electrode 127 is not arranged). The n-type electrode 127 can be formed by a sputtering method, an electron beam vapor deposition method, or the like.

### Insulating Film Forming Step

For example, as illustrated in FIG. 16, the insulating film forming step is a step of forming the first insulating film 3 on the first end surface 20a of the light-emitting element precursor 20. The first insulating film 3 can be formed by a sputtering method, an electron beam vapor deposition method, or the like using the above-described material. At this time, the first insulating film 3 is also formed on at least one of the pair of side surfaces 20c connecting the first end surface 20a and the second end surface 20b in the light-emitting element precursor 20 by appropriately selecting sputtering conditions and vapor deposition conditions. In the insulating film forming step, the second insulating film 4 may be formed on the second end surface 20b of the light-emitting element precursor 20, which is opposed to the first end surface 20a.

As described above, the light-emitting element 1 can be manufactured. The first end surface 20a and the second end surface 20b are resonator surfaces of the light-emitting element 1. The support substrate 30 may be removed from the light-emitting element 1 after completion of the insulating film forming step, or may be used as a submount when the light-emitting element 1 is mounted on a semiconductor package.

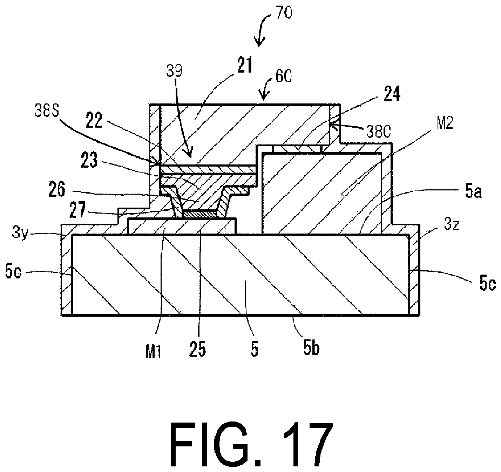

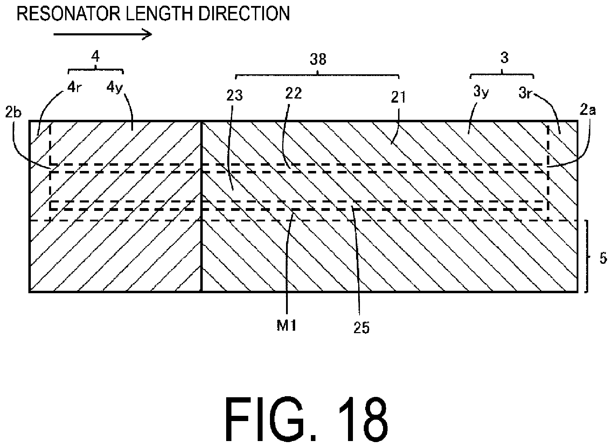

FIG. 17 is a cross-sectional view of an example of the semiconductor laser element. FIG. 18 is a side view of an example of the semiconductor laser element. As illustrated in FIGs. 17 and 18, a semiconductor laser element 70 includes the base 5, a nitride semiconductor layer 38 located above the base 5 and including an optical resonator 39, a first light reflecting film 3r in contact with one (2a) of a pair of resonator end surfaces 2a and 2b of the optical resonator 39, and a first dielectric film 3y made of the same material as the first light reflecting film 3r and in contact with a side surface 38S of the nitride semiconductor layer 38 along a resonator length direction. The first dielectric film 3y may be a light-reflective layered film. The base 5 may be a submount substrate (for example, a Si substrate or a SiC substrate) (which is not a substrate for growing a nitride semiconductor). The resonator end surface 2a may be an end surface on the light reflection side, and the resonator end surface 2b may be an end surface on the light-emitting side.

The first light reflecting film 3r may be a dielectric film made of a dielectric material containing at least one of Al₂O₃, AlN, MgF₂, MgO, Nb₂O₅, SiO₂, Si₃N₄, TiO₂, Ta₂O₅, Y₂O₃, ZnO, and ZrOz. The nitride semiconductor layer 38 is a semiconductor layer containing a nitride semiconductor (for example, a GaN-based semiconductor) represented by, for example, AlₓGa_{y}In_{z}N (0 ≤ x ≤ 1; 0 ≤ y ≤ 1; 0 ≤ z ≤ 1; x + y + z = 1). The nitride semiconductor layer 38 may include the n-type semiconductor layer 21, the active layer 22, and the p-type semiconductor layer 23. Each of the n-type semiconductor layer 21 and the p-type semiconductor layer 23 may include an optical guide layer and a cladding layer. A ridge may be provided in the p-type semiconductor layer 23. The insulating layer 27 may be provided to cover the side surface of the ridge. The first dielectric film 3y may be in contact with a side surface of at least one of the n-type semiconductor layer 21, the active layer 22, and the p-type semiconductor layer 23. Light generated by recombining electrons from the n-type semiconductor layer 21 and holes from the p-type semiconductor layer 23 in the active layer 22 is amplified by the optical resonator 39 and emitted as laser light (for example, from the resonator end surface 2b). By forming the first dielectric film 3y, the likelihood of occurrence of a side short-circuit is reduced. Side surface deterioration of the nitride semiconductor layer 38 (for example, side surface deterioration of the active layer) is suppressed. The resonator length (distance between the resonator end surfaces) may be 200 µm or less.

The semiconductor laser element 70 may include a bonding layer M1 located on the base 5 and the electrode 25 (for example, anode) bonded to the bonding layer M1. The bonding layer M1 may be a solder layer containing a solder material such as Au or Sn. The nitride semiconductor layer 38 may be mounted on the base 5 having the bonding layer M1 thereon. The first dielectric film 3y may be in contact with a side surface of the bonding layer M1. The first dielectric film 3y may be in contact with the side surface of the electrode 25 or may be in contact with the insulating layer 27. The first dielectric film 3y may be in contact with the side surface 5c of the base 5. The first light reflecting film 3r and the first dielectric film 3y may be connected to form the first insulating film 3.

The semiconductor laser element 70 may include: (i) a second light reflecting film 4r in contact with the other (2b) of the pair of resonator end surfaces 2a and 2b; and (ii) a second dielectric film 4y made of the same material as the second light reflecting film 4r and in contact with the side surface 38S of the nitride semiconductor layer 38 along the resonator length direction. The second light reflecting film 4r and the second dielectric film 4y may be connected to form the second insulating film 4. When the resonator end surface 2b is on the light-emitting side, the first light reflecting film 3r may have a higher light reflectance than the second light reflecting film 4r, and the first dielectric film 3y may be thicker than the second dielectric film 4y. The area of the first dielectric film 3y may be greater than the area of the second dielectric film 4y.

The first light reflecting film 3r may cover the resonator end surface 2a on the light reflecting side. The resonator end surfaces 2a and 2b may be m-planes ({1-100} planes) of the nitride semiconductor layer 38. The semiconductor laser element 70 may include a third dielectric film 3z which is made of the same material as the first light reflecting film 3r and is in contact with the other side surface 38C (a side surface paired with the side surface 38S) of the nitride semiconductor layer 38 along the resonator length direction. The third dielectric film 3z may be connected to the first light reflecting film 3r. The third dielectric film 3z may be in contact with the side surfaces of the bonding layers M2 bonded to the electrode 24 (for example, cathode). The third dielectric film 3z may be in contact with a side surface of the electrode 24. The third dielectric film 3z may be in contact with the side surface 5c of the base 5.

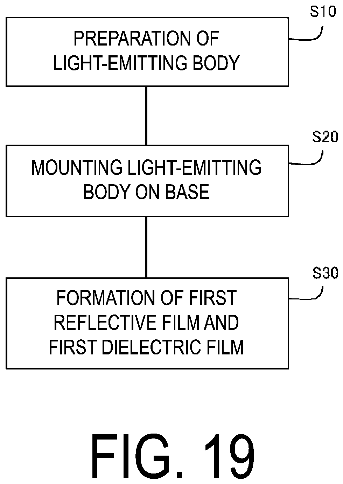

FIG. 19 is a flowchart showing an example of a method for manufacturing a semiconductor laser element. In FIG. 19, a step S10 of preparing a light-emitting body 60 including the nitride semiconductor layer 38, which includes the optical resonator 39, and the electrodes 24, 25; a step S20 of mounting the light-emitting body 60 above the base 5; and a step S30 of forming, with respect to the light-emitting body 60 that has been mounted, the first light reflecting film 3r in contact with one (2a) of a pair of resonator end surfaces 2a and 2b of the optical resonator 39, and the first dielectric film 3y made of the same material as the first light reflecting film 3r and in contact with a side surface 38S of the nitride semiconductor layer 38 along the resonator length direction are performed. In the step S30, a sputtering method, an electron beam vapor deposition method, or the like can be applied. However, in the process of supplying the material (dielectric material) of the first light reflecting film 3r to the resonator end surface 2a, the first dielectric film 3y may be formed by wrapping the material around the side surface 38S. Similarly, in FIGs. 17 and 18, in the process of supplying the material of the second light reflecting film 4r to the resonator end surface 2b on the light-emitting side, the second dielectric film 4y may be formed by wrapping the material around the side surface 38S. The first dielectric film 3y and the second dielectric film 4y may be in contact with (overlap with) each other. The second light reflecting film 4r and the second dielectric film 4y may be formed after the first light reflecting film 3r and the first dielectric film 3y are formed, or the first light reflecting film 3r and the first dielectric film 3y may be formed after the second light reflecting film 4r and the second dielectric film 4y are formed.

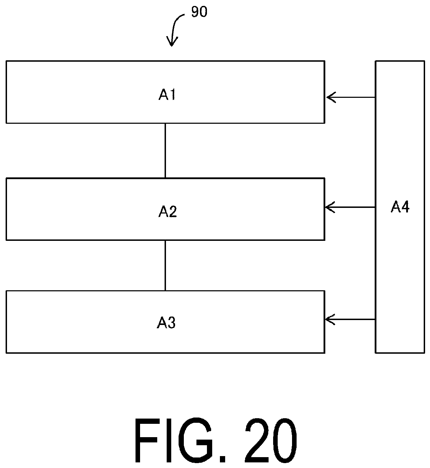

FIG. 20 is a flowchart showing an example of an apparatus for manufacturing a semiconductor laser element. The apparatus 90 of the semiconductor laser element includes an apparatus A1 for preparing the light-emitting body 60 having the nitride semiconductor layer 38 including the optical resonator 39 and the electrodes 24, 25, an apparatus A2 for mounting the light-emitting body 60 on the base 5, an apparatus A3 for forming the first light reflecting film 3r in contact with one (2a) of a pair of resonator end surfaces 2a and 2b of the optical resonator 39, and the first dielectric film 3y made of the same material as the first light reflecting film 3r, and in contact with the side surface 38S of the nitride semiconductor layer 38 along the resonator length direction, and a control apparatus A4 for controlling the apparatuses A1, A2 and A3.

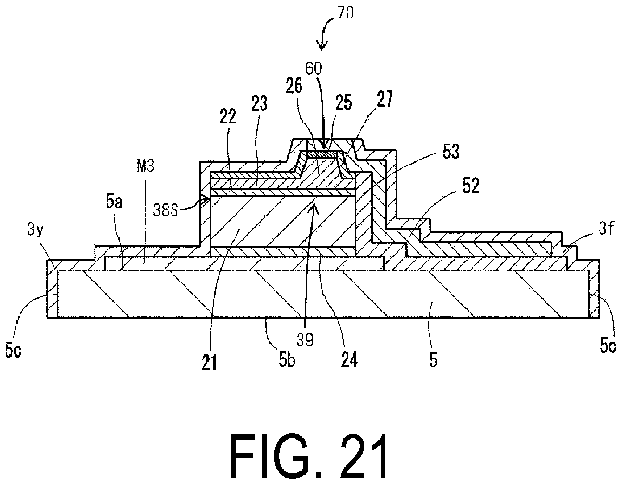

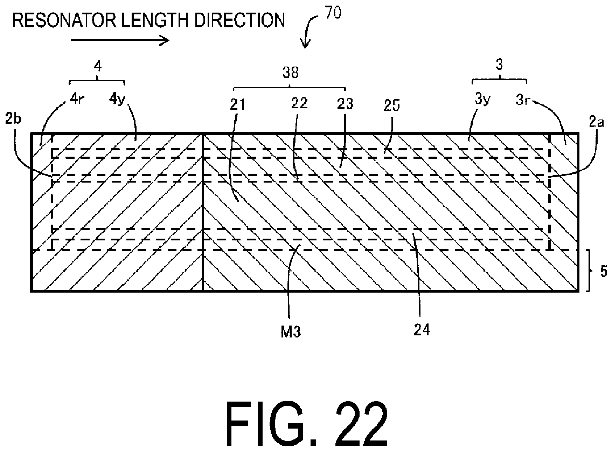

FIG. 21 is a cross-sectional view of another example of the semiconductor laser element. FIG. 22 is a side view of an example of the semiconductor laser element. As illustrated in FIGs. 21 and 22, a semiconductor laser element 70 includes the base 5, a nitride semiconductor layer 38 located above the base 5 and including an optical resonator 39, the first light reflecting film 3r in contact with one (2a) of a pair of resonator end surfaces 2a and 2b of the optical resonator 39, and the first dielectric film 3y made of the same material as the first light reflecting film 3r and in contact with a side surface 38S of the nitride semiconductor layer 38 along a resonator length direction. The first dielectric film 3y may be in contact with a side surface of at least one of the n-type semiconductor layer 21, the active layer 22, and the p-type semiconductor layer 23. By forming the first dielectric film 3y, the likelihood of occurrence of a side short-circuit is reduced. Side surface deterioration of the nitride semiconductor layer 38 is suppressed. The resonator end surface 2b may be an end surface on the light-emitting side.

The semiconductor laser element 70 includes a bonding layer M3 located on the base 5 and the electrode 24 (for example, cathode) bonded to the bonding layer M3. The bonding layer M3 may be a solder layer containing a solder material such as Au or Sn. The first dielectric film 3y may be in contact with a side surface of the bonding layer M3. The first dielectric film 3y may be in contact with the side surface of the electrode 24. The first dielectric film 3y may be in contact with the side surface 5c of the base 5. The first light reflecting film 3r and the first dielectric film 3y may be connected to form the first insulating film 3.

The semiconductor laser element 70 may include: the second light reflecting film 4r in contact with the other (2b) of the pair of resonator end surfaces 2a and 2b; and the second dielectric film 4y made of the same material as the second light reflecting film 4r and in contact with the side surface 38S of the nitride semiconductor layer 38 along the resonator length direction. The second light reflecting film 4r and the second dielectric film 4y may be connected to form the second insulating film 4. When the resonator end surface 2b is on the light-emitting side, the first light reflecting film 3r may have a higher light reflectance than the second light reflecting film 4r, and the first dielectric film 3y may be thicker than the second dielectric film 4y. The area of the first dielectric film 3y may be greater than the area of the second dielectric film 4y.

The first light reflecting film 3r may cover the resonator end surface 2a on the light-emitting side. The semiconductor laser element 70 may include a fourth dielectric film 3f located on the opposite side of the first dielectric film 3y with respect to the nitride semiconductor layer 38, and the fourth dielectric film 3f may be made of the same material as the first light reflecting film 3r. The fourth dielectric film 3f may be connected to the first light reflecting film 3r. The electrode 25 (for example, anode) may be electrically connected to the wiring electrode 52, and the fourth dielectric film 3f may cover the wiring electrode 52. The fourth dielectric film 3f may be in contact with the side surface 5c of the base 5.

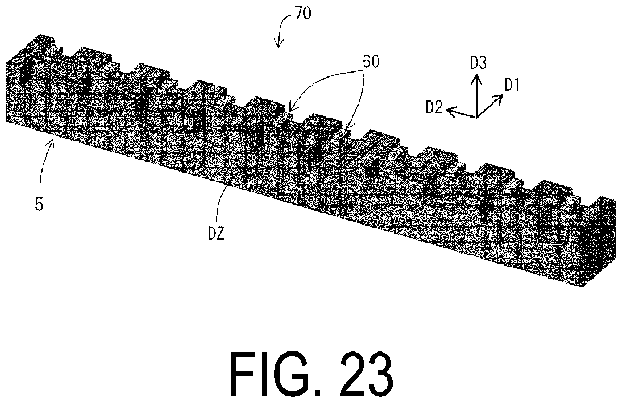

FIG. 23 is a perspective view of an example of the semiconductor laser element. As illustrated in FIG. 23, in the semiconductor laser element 70, a plurality of light-emitting bodies 60 each including an optical resonator may be arranged above the base 5 in a direction (D2 direction) orthogonal to the resonator length direction (D1 direction). The semiconductor laser element 70 illustrated in FIG. 23 can be obtained by mounting the plurality of light-emitting bodies 60 on the base 5 by, for example, a transfer method and then coating the light-emitting bodies 60 with a dielectric material.

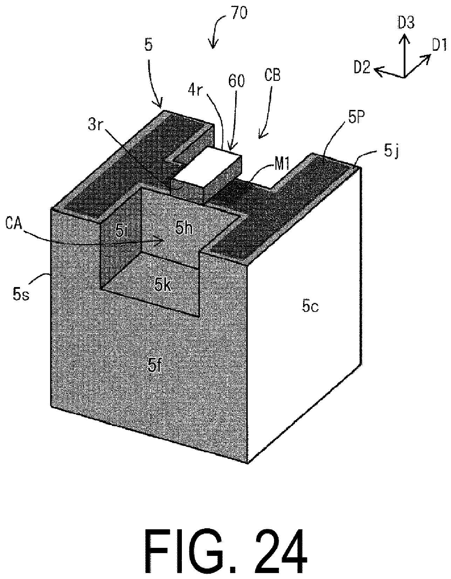

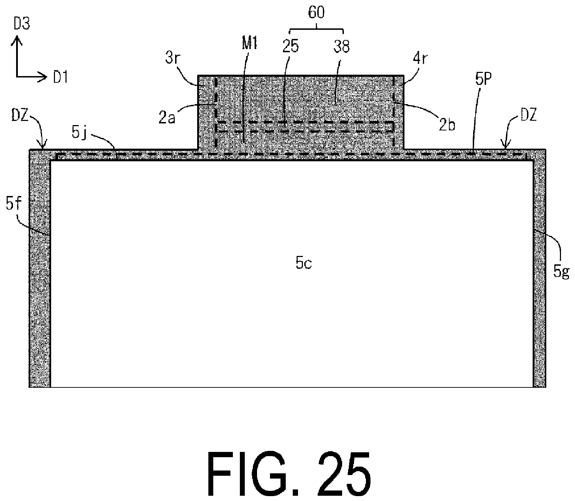

FIG. 24 is a perspective view of an example of the semiconductor laser element. The semiconductor laser element 70 of FIG. 23 may be singulated as illustrated in FIG. 24. FIG. 25 is a side view of the semiconductor laser element of FIG. 24. In the semiconductor laser element 70 illustrated in FIGs. 24 and 25, the base 5 has a plurality of surfaces (5f and the like) in addition to the surface (upper surface) 5j on the side on which the light-emitting body 60 is mounted, and the plurality of surfaces may include the following surfaces. For example, the plurality of surfaces may include (i) the surface 5f on which the dielectric material DZ of the same material as the first light reflecting film 3r is disposed and the normal direction thereof is parallel to the D1 direction, and (ii) the surface 5c on which the dielectric material DZ is not disposed and the normal direction thereof is orthogonal to the D1 direction. The dielectric material DZ provided on the surface 5f can function as a protective film. On the other hand, since the dielectric material DZ is not formed on the surface 5c (side surface), the heat dissipation property can be secured. The dielectric material DZ may be disposed on the surface 5g facing the surface 5f. The dielectric material DZ of the surface 5g located on the resonator end surface 2b (for example, laser emission surface) side may be thinner than the dielectric material DZ of the surface 5f located on the resonator end surface 2a side. The dielectric material DZ need not be disposed on the surface 5s (side surface) facing the surface 5c. The base 5 may include a silicon carbide (SiC) substrate having a higher thermal conductivity than the Si substrate.

The cutouts CA and CB may be provided in the upper portion of the base 5 to face each other in the D1 direction. For example, the dielectric material DZ of the same material as the first light reflecting film 3r may be disposed on at least one of the surface 5 h (normal parallel to the D1 direction), the surface Si (normal parallel to the D2 direction), and the surface 5k (normal parallel to the D3 direction) formed in the rectangular parallelepiped cutout CA. In particular, the dielectric material DZ may be disposed on the surface 5h parallel to the resonator end surface 2a. The light-emitting body 60 may be mounted such that the resonator end surface 2b (light-emitting side) protrudes over the cutout portion CB.

The dielectric material DZ made of the same material as the first light reflecting film 3r may be disposed on the upper surface 5j. The light-emitting body 60 may include the electrode 25 in contact with the nitride semiconductor layer 38. The conductive pad 5P electrically connected to the electrode 25 via the bonding layer M1 may be disposed on the upper surface 5j. The dielectric material DZ of the same material as the first light reflecting film 3r may be disposed on the conductive pad 5P.

These are detailed descriptions of the embodiments of the present disclosure. However, the present disclosure is not limited to the embodiments described above, and various modifications or improvements or the like can be made without departing from the main points of the present disclosure.

### REFERENCE SIGNS

1, 1A Light-emitting element
2 Laminate
2a First end surface
2b Second end surface
2c Side surface
2d First main surface
2d1 Non-electrode region
2e Second main surface
21 N-type semiconductor layer
21a One main surface
22 Active layer
23 P-type semiconductor layer
23a One main surface
24 First electrode (n-type electrode, cathode)
25 Second electrode (p-type electrode, anode)
26 Ridge waveguide
27 Insulating layer
3 First insulating film
3a, 3b End portion
3r First light reflecting film
3y First dielectric film
4 Second insulating film
4r Second light reflecting film
4y Second dielectric film
5 Support base (base)
5a One main surface
5b Other main surface
5c Side surface
51 First bonding layer
52 Wiring electrode
53 Insulating layer
54 Third bonding layer
55 Fourth bonding layer
10 Underlying substrate
10a One main surface
11 Mask
11a Band-shaped portion
12 Semiconductor element layer
121 N-type semiconductor layer
121a One main surface (upper surface)
122 Active layer
123 P-type semiconductor layer
123a One main surface (upper surface)
124 Ridge waveguide
125 Insulating layer
126 P-type electrode
127 N-type electrode
20 Light-emitting element precursor
20a First end surface
20b Second end surface
20c Side surface
20d Connecting portion
30 Support substrate
30a One main surface (lower surface)
M1 to M3 Bonding layer

## Claims

1. A light-emitting element comprising:
a laminate comprising a plurality of semiconductor layers and comprising a first end surface, a second end surface opposed to the first end surface, and a pair of side surfaces connecting the first end surface and the second end surface; and
a first insulating film located over at least one of the pair of side surfaces from the first end surface.

2. The light-emitting element according to claim 1, wherein
the first end surface is a light-emitting surface, and
the second end surface is a light reflecting surface.

3. The light-emitting element according to claim 1 or 2, wherein
the laminate further comprises a first main surface and a second main surface connected to the first end surface, the second end surface, and the pair of side surfaces, and
a first electrode and a second electrode are disposed on the first main surface and the second main surface, respectively.

4. The light-emitting element according to claim 3, wherein
the first main surface has a non-electrode region where the first electrode is not located, and
the first insulating film is located over the non-electrode region from the first end surface.

5. The light-emitting element according to claim 4, wherein
an end portion of a portion of the first insulating film located on at least one of the pair of side surfaces is located closer to the second end surface than an end portion of a portion of the first insulating film located in the non-electrode region.

6. The light-emitting element according to any one of claims 1 to 5, further comprising:
a second insulating film located over at least one of the pair of side surfaces from the second end surface.

7. The light-emitting element according to claim 6, wherein
the first insulating film or the second insulating film is located over both of the pair of side surfaces.

8. The light-emitting element according to claim 6 or 7 depending on claim 3, wherein
the first insulating film or the second insulating film is located over the second electrode from the first end surface or the second end surface.

9. The light-emitting element according to any one of claims 6 to 8, wherein
the first insulating film or the second insulating film is configured to cover at least one of the pair of side surfaces.

10. The light-emitting element according to any one of claims 6 to 9, wherein
on the pair of side surfaces, a region where the second insulating film is disposed is larger than a region where the first insulating film is disposed.

11. The light-emitting element according to any one of claims 6 to 10, wherein
on the pair of side surfaces, an end portion of the first insulating film is located on the second insulating film.

12. The light-emitting element according to any one of claims 6 to 11, wherein
the second insulating film has a material different from a material of the first insulating film.

13. The light-emitting element according to any one of claims 6 to 12, wherein
a reflectance of the second insulating film is higher than a reflectance of the first insulating film.

14. The light-emitting element according to any one of claims 1 to 13, wherein
at least one of the first end surface and the second end surface is a cleavage plane.

15. The light-emitting element according to any one of claims 1 to 14, wherein
at least one of the first end surface and the second end surface has a crystal plane having a crystal orientation of (1-100).

16. A semiconductor laser element comprising:
a base;
a nitride semiconductor layer located above the base and comprising an optical resonator;
a first light reflecting film in contact with one of a pair of resonator end surfaces of the optical resonator; and
a first dielectric film made of the same material as the first light reflecting film and being in contact with a side surface of the nitride semiconductor layer along a resonator length direction.

17. The semiconductor laser element according to claim 16, wherein
the nitride semiconductor layer comprises an n-type semiconductor layer, an active layer, and a p-type semiconductor layer, and
the first dielectric film is in contact with a side surface of at least one selected from the group consisting of the n-type semiconductor layer, the active layer, and the p-type semiconductor layer.

18. The semiconductor laser element according to claim 16, further comprising:
a bonding layer located on the base, wherein
the first dielectric film is in contact with a side surface of the bonding layer.

19. The semiconductor laser element according to claim 18, further comprising:
an electrode bonded to the bonding layer, wherein
the first dielectric film is in contact with a side surface of the electrode.

20. The semiconductor laser element according to any one of claims 16 to 19, wherein
the first dielectric film is in contact with a side surface of the base.

21. The semiconductor laser element according to any one of claims 16 to 20, wherein
the first light reflecting film and the first dielectric film are connected to each other.

22. The semiconductor laser element according to any one of claims 16 to 21, wherein
a second light reflecting film in contact with the other of the pair of resonator end surfaces, and
a second dielectric film made of the same material as the second light reflecting film and in contact with a side surface of the nitride semiconductor layer along the resonator length direction.

23. The semiconductor laser element according to claim 22, wherein
the first dielectric film is thicker than the second dielectric film.

24. The semiconductor laser element according to claim 23, wherein
an area of the first dielectric film is greater than an area of the second dielectric film.

25. The semiconductor laser element according to any one of claims 16 to 24, wherein
the first light reflecting film is configured to cover a resonator end surface on a light reflecting side.

26. The semiconductor laser element according to any one of claims 16 to 25, further comprising:
a third dielectric film made of the same material as the first light reflecting film and in contact with the other side surface of the nitride semiconductor layer along the resonator length direction.

27. The semiconductor laser element according to claim 16, further comprising:
a light-emitting body comprising the nitride semiconductor layer, wherein
the base has a plurality of surfaces in addition to a surface on a side on which the light-emitting body is mounted, and
the plurality of surfaces comprise one or more surfaces having a normal direction parallel to the resonator length direction and having a surface on which a dielectric material of the same material as the first light reflecting film is disposed, and one or more surfaces having a normal direction orthogonal to the resonator length direction and having a surface on which a dielectric material is not formed.

28. The semiconductor laser element according to claim 27, wherein
a dielectric material of the same material as the first light reflecting film is disposed on a surface on a side on which the light-emitting body is mounted.

29. The semiconductor laser element according to claim 27 or 28, wherein
a cutout portion is provided in an upper portion of the base, and
a dielectric material of the same material as the first light reflecting film is disposed on one or more surfaces formed in the cutout portion.

30. The semiconductor laser element according to any one of claims 27 to 29, wherein
the light-emitting body comprises an electrode in contact with the nitride semiconductor layer,
a conductive pad electrically connected to the electrode is disposed on a surface on a side on which the light-emitting body is mounted, and
a dielectric material of the same material as the first light reflecting film is disposed on the conductive pad.

31. A method for manufacturing a semiconductor laser element, the method comprising:
preparing a light-emitting body comprising a nitride semiconductor layer comprising an optical resonator, and an electrode;
mounting the light-emitting body over a base;
forming, with respect to the mounted light-emitting body, a first light reflecting film in contact with one of a pair of resonator end surfaces of the optical resonator and a first dielectric film that is made of the same material as the first light reflecting film and is in contact with a side surface of the nitride semiconductor layer along a resonator length direction.

32. The method for manufacturing a semiconductor laser element according to claim 31, wherein
the first dielectric film is formed by wraparound of a material supplied toward one of the resonator end surfaces.

33. An apparatus for manufacturing a semiconductor laser element, which performs the steps according to claim 31.
